# EUROPEAN PATENT APPLICATION

(11) **EP 4 723 514 A1**
(43) Date of publication of application: **08.04.2026**
(21) Application number: 23943623.1
(22) Date of filing: 28.06.2023
(51) Int. Cl.: H04B 10/40, H04B 10/50, H04B 10/60

(54) **OPTICAL TRANSCEIVER**

(71) Applicant: NTT, Inc., Tokyo 100-8116 (JP)
(72) Inventor: OZAKI Josuke, Musashino-shi, Tokyo 180-8585 (JP); OGISO Yoshihiro, Musashino-shi, Tokyo 180-8585 (JP); NUNOYA Nobuhiro, Musashino-shi, Tokyo 180-8585 (JP)
(74) Representative: Samson & Partner Patentanwälte mbB
(86) International application number: PCT/JP2023/024011
(87) International publication number: WO 2025/004226

(57) **Abstract**

An optical transceiver is disclosed that implements smooth high frequency connection between a DSP and an optical module. The optical module may include an optical receiver module and an optical modulator module. The optical transceiver may include a single optical module in which functions of both the optical receiver and the optical modulator are integrated. The high frequency connection is implemented by a flexible circuit board (FPC), and the FPC electrically connects between a PAD on the upper surface of a DSP circuit board and a PAD of a package of the optical module. A connection PAD on one surface of the FPC is connected to the DSP circuit board side, and a connection PAD on the other surface is connected to the optical module side. A DSP chip may be mounted on the DSP circuit board, and the entire DSP may be covered with a lid except for a region of the DSP circuit board connected to the FPC.

## Description

### Technical Field

The present invention relates to an optical transceiver used in optical communication. More particularly, it relates to a mounting form of an optical transceiver.

### Background Art

In order to cope with increasing communication traffic demand, a high-speed optical modulator and optical receiver compatible with an advanced optical modulation system is required. In optical modulators and optical receivers in early 100G digital coherent communication systems, each of the components has been packaged and mounted on a printed circuit board (PCB). For example, in the case of an optical modulator, a driver IC and an optical modulator chip are individually packaged, and the packaged IC and chip are mounted on a PCB. In the case of an optical receiver, a transimpedance amplifier (TIA) and an optical receiver chip have been each packaged separately and mounted as separate components on a PCB.

In a digital coherent communication system that exceeds 400G in which the speed is further increased, an optical modulator and an optical receiver are also required to have a wide band so as to be able to handle a signal of 40 GHz or more, and a high frequency loss needs to be reduced and a size needs to be reduced. In the case of an optical modulator, a driver IC and an optical modulator chip are integrally mounted in one package as an optical module. Also in the case of an optical receiver, a TIA and an optical receiver chip are integrally mounted as a single optical module. Also for a signal format for inputting and outputting a baseband signal, design from a single-ended format to a differential format has been generalized as one of means for implementing high speed, small size, and low power consumption. At present, device development for implementing 800 Gbps and 1 Tbps (128 GBd operation) is in progress.

The Optical Internetworking Forum (OIF) is standardized under the name of a High-Bandwidth Coherent Driver Modulator (HB-CDM) as an optical transmitter in which a driver IC and an optical modulator are mounted in an integrated package. In Non Patent Literature 1, physical configurations, interface specifications, and the like are defined as various types of modules. Also on the reception side, a TIA and an optical receiver are mounted in an integrated package, which is also said to be a high-bandwidth intradyne coherent receiver (HB-ICR). An optical transceiver (optical transceiver device) includes an optical module on a transmission side (Tx) and an optical module on a reception side (Rx).

Initially, in the above-described optical module, a surface mount (surface mount technology [SMT]) type package having excellent mountability has been used. In the optical module of the SMT type package, since the optical module is mounted on the PCB of the optical transceiver, a via (VIA) structure for passing a high-frequency electrical signal into the package is essential. In the VIA, deterioration of high frequency characteristics and the like are inevitable, and thus the VIA structure is not suitable for further achieving a wide band. Furthermore, in the SMT type package, in a connection portion between a lead pin and a ceramic package, the high-frequency transmission characteristics of an electrical signal have been also deteriorated due to electromagnetic field mode mismatching or impedance mismatching (Non Patent Literature 2). Therefore, a package configuration using a flexible wiring board (flexible printed circuit [FPC]) is newly standardized (Non Patent Literature 1).

### Citation List

### Patent Literature

Patent Literature 1: WO 2021/171599 A

### Non Patent Literature

Non Patent Literature 1: OIF, Implementation Agreement for the High Bandwidth Coherent Driver Modulator (HB-CDM), [online], July 15, 2021, [retrieved on June 20, 2023], Internet <URL: https://www.oiforum.com/wp-content/uploads/OIF-HB-CDM-02.0.pdf>
Non Patent Literature 2: J. Ozaki et al., "Over-85-GHz-Bandwidth InP-Based Coherent Driver Modulator Capable of 1-Tb/s/λ-Class Operation," in Journal of Lightwave Technology, vol. 41, no. 11, pp. 3290-3296, 1 June1, 2023, doi: 10.1109/JLT.2023.3236962.

### Summary of Invention

### Technical Problem

Optimized design including a digital signal processor (DSP) is important in implementing a high speed of the entire optical transceiver in addition to a high speed of each optical module. In early optical transceivers, the DSP, a transmission module, and a reception module have been mounted in separate packages and mounted at separate locations on a PCB. For this reason, there has been a limit to speed up of the optical transceiver due to a propagation loss generated in each of the packages or on the PCB. As one of the solutions, a "co-package structure" in which an optical modulator chip, an optical receiver chip, and a DSP are mounted close to each other in a single package has also been studied. This structure is an ideal structure that can greatly reduce the loss of a high-frequency electrical signal, but the DSP that is the largest heat source is disposed close to the periphery of the optical modulator or the optical receiver. In a case where an optical modulator that requires temperature control, such as an InP modulator that is excellent in speed, is used, the optical modulator chip needs to be mounted on a Peltier element. The Peltier element includes a risk of an increase in power consumption and thermal runaway, and mounting the Peltier element in a single package close to the periphery of the DSP that causes heat inflow is difficult. The co-package structure includes various issues in terms of a mounting process and also in implementation. Therefore, another configuration of the optical transceiver has been proposed (Patent Literature 1).

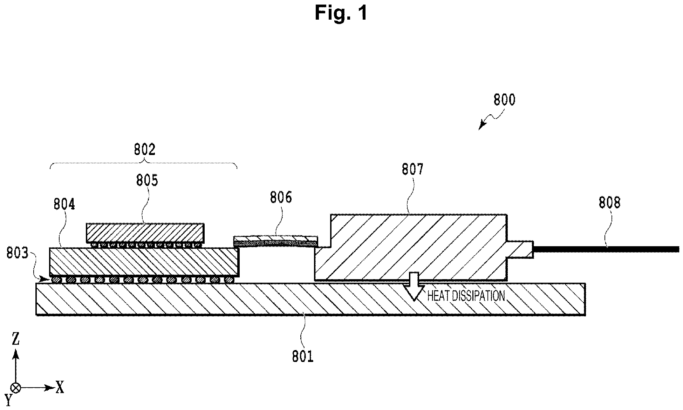

Fig. 1 is a side sectional view illustrating a configuration of a conventional optical transceiver adapted for high speed. A side cross section (z-x plane) of an optical transceiver 800 taken along a line passing through a transmission module 807 mounted on a circuit board surface (x-y plane) of a PCB 801 is illustrated. The optical transceiver 800 includes a DSP 802, the transmission module 807, and a reception module (not illustrated). In the DSP 802, a DSP chip 805 is mounted on a DSP circuit board 804 by a ball grid array (BGA). The entire DSP 802 is further mounted on a PCB 801 with a BGA 803. The transmission module 807 includes a driver IC, an optical modulator chip, and the like (not illustrated) in a package including a terrace, and includes an optical fiber 808.

In the optical transceiver 800, a radio frequency (RF) signal is connected between the DSP 802 and the optical module 807 by an FPC 806. By utilizing the FPC 806 as an RF interface, an RF signal line formed on the upper surface of the DSP circuit board 804 and an RF signal line on the terrace of the optical module are directly connected. In an initial optical transceiver including an optical module of the SMT type package, a signal path passing through a VIA of the DSP circuit board 804, an RF signal line pattern of the PCB 801, and a VIA of the package of the optical module 807 has been formed. The optical transceiver 800 of Fig. 1 is formed to minimize a high frequency loss as compared to early optical transceivers that utilize the SMT type package. Furthermore, options of optical modulators are not limited as in an optical transceiver including a co-package structure, and mounting is more feasible.

However, in the optical transceiver 800 of the conventional art in Fig. 1, a specific configuration of connection between the FPC 806 and the DSP circuit board 802, a structure of the FPC 806, and a configuration of connection between the FPC 806 and the optical module 807 are not clear. The configurations of the DSP and the DSP circuit board are also not clear. Furthermore, in the transmission module 807 of Fig. 1, a heat generating component such as the driver IC inside the package is thermally connected to the side where the terrace is located and the PCB side, and the heat dissipation direction is below the optical transceiver 800 (-z direction). On the other hand, since the DSP chip 805 is on the upper side in the DSP 802, the heat dissipation direction is above the optical transceiver (+z direction). The direction of heat dissipation is separated in two directions, which is not preferable for simplifying the heat dissipation structure.

An object of the present invention is to provide an optical transceiver that presents a configuration of smooth high frequency connection between a DSP and an optical module in the optical transceiver and can operate at an ultra-high speed.

### Solution to Problem

One aspect of the present invention is an optical transceiver including: at least one optical module mounted on a printed circuit board (PCB); a digital signal processor (DSP) mounted on the PCB; and a flexible wiring board (flexible printed circuit [FPC]) that connects the DSP and the optical module, in which the DSP includes a DSP chip mounted on a DSP circuit board, the FPC includes a first connection PAD of a first surface solder-connected to a PAD of a terrace surface of the optical module and a second connection PAD of a second surface solder-connected to a PAD of an upper surface of the DSP circuit board, and the PAD of the DSP circuit board is connected to the DSP chip by a signal line of an inner layer of a multilayer wiring circuit board from the PAD on the DSP circuit board via a via (VIA).

### Advantageous Effects of Invention

According to the present invention, quality degradation of a high-frequency signal is reduced, and broadband and high-speed operation of an optical transceiver is implemented.

### Brief Description of Drawings

Fig. 1 is a side sectional view illustrating a configuration of a conventional optical transceiver adapted for high speed.
Fig. 2 is a top view and a cross-sectional view illustrating an outline of a configuration of an optical transceiver of the present disclosure.
Fig. 3 is an enlarged cross-sectional view of an optical module including connection portions of an FPC.
Fig. 4 is a view illustrating another configuration example 2 of a DSP lid of the optical transceiver of the present disclosure.
Fig. 5 is a view illustrating another configuration example 3 of the DSP lid of the optical transceiver of the present disclosure.
Fig. 6 is a view illustrating another configuration example 4 of the DSP lid of the optical transceiver of the present disclosure.
Fig. 7 is a view illustrating an FPC wiring layout in the optical transceiver of the present disclosure.
Fig. 8 is a view illustrating another configuration example of the FPC in the optical transceiver of the present disclosure.
Fig. 9 is a view illustrating a configuration of a signal line and an internal layer structure in a DSP circuit board.
Fig. 10 is a diagram illustrating a simulation calculation result of inter-channel crosstalk.
Fig. 11 is a view illustrating a configuration of a signal line of a multilayer DSP circuit board including a core layer.
Fig. 12 is a view illustrating another configuration of a signal line of a multilayer DSP circuit board including a core layer.
Fig. 13 is a view illustrating half-through holes formed at an end portion of a DSP circuit board.
Fig. 14 is a view illustrating a cross-sectional structure of a Tx module of the optical transceiver of the present disclosure.

### Description of Embodiments

An optical transceiver of the present disclosure presents a specific configuration that implements smooth high-frequency connection between a DSP and an optical module. The optical module may include an optical receiver module and an optical modulator module. The optical transceiver may include two separate optical modules, or may include a single optical module in which functions of both the optical receiver and the optical modulator are integrated. For high-frequency connection, a flexible circuit board (hereinafter, FPC) is used. The FPC electrically connects a PAD on the upper surface of the DSP circuit board and a PAD of a package of an optical module using both surfaces. A connection PAD on one surface of the FPC is connected to the DSP circuit board side, and a connection PAD on the other surface is connected to the optical module side. In the DSP, a DSP chip may be mounted on a DSP circuit board, and the entire DSP may be covered with a lid except for a region of the DSP circuit board connected to the FPC.

A detailed structure of the connection PAD in the DSP circuit board, a shape of a high-frequency wiring, a structure of a multilayer wiring circuit board, and a structure of the FPC for avoiding deterioration of transmission characteristics of a high-frequency signal due to impedance mismatching, high-frequency crosstalk, and the like is disclosed. Hereinafter, a detailed configuration of the optical transceiver will be described with reference to the drawings.

In the following description, for the sake of simplicity, an optical module on the transmission side including the optical modulator and its driver IC is referred to as a "Tx module", and an optical module on the reception side including a photodetector (PD) and the TIA is referred to as an "Rx module". A single optical module in which functions of both the Tx module and the Rx module are integrated is referred to as a TRx module. In the following description, an optical transceiver including the Rx module and the Tx module is described as an example, but two modules may be replaced with one TRx module. Furthermore, in the following description, the description will be made on the basis of the cross section of the Tx module, but the connection form of the DSP and the optical module by the FPC is the same for the Rx module having a substantially symmetrical shape with the Tx module. The similar configuration of the PAD shape of the FPC between the DSP and the Tx module and the PAD shape of the FPC between the DSP and the Rx module is efficient also in terms of high frequency design. Variations in solder mounting quality and connection strength can also be reduced in the entire optical module.

### [Basic Configuration of Optical Transceiver]

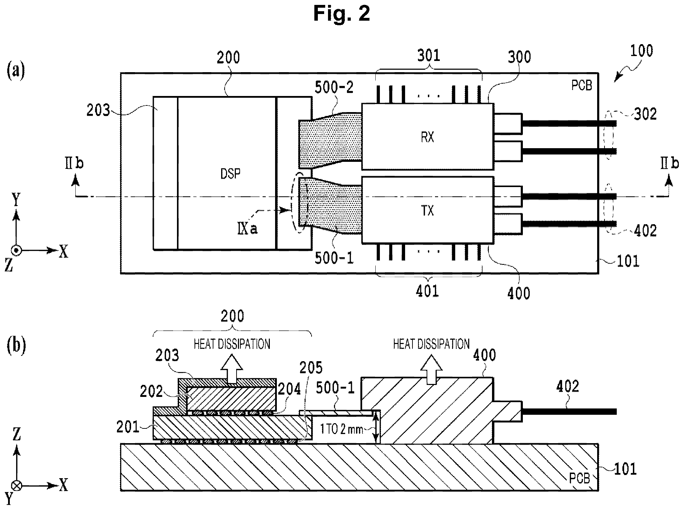

Fig. 2 is a top view and a cross-sectional view illustrating an outline of a configuration of the optical transceiver of the present disclosure. (a) of Fig. 2 is a top view of a circuit board surface (x-y plane) of a PCB 101, and (b) is a side sectional view (x-z plane) taken along IIb-IIb passing through a Tx module 400. In an optical transceiver 100, a DSP 200, an Rx module 300, and a Tx module 400 are mounted on the PCB 101.

Furthermore, various electric components and mechanical components including a chip capacitor, a resistor, and the like are mounted on the upper surface and the lower surface of the PCB 101, but are omitted in Fig. 1. In the optical transceiver 100, the heat dissipation surfaces of the DSP 200, the Rx module 300, and the Tx module 400 are aligned in one direction in consideration of manufacturability in a case where each component is mounted on the PCB 101, simplification of a heat dissipation structure of the optical transceiver, and the like. Considering that heat generation from the DSP chip 202 is maximum in the optical transceiver, the directions of heat dissipation are desirably aligned in the upper direction (+z direction) appropriate for heat dissipation of the DSP chip 202.

Referring to the cross-sectional view in (b) of Fig. 2, in contrast to the configuration of the conventional art, the optical module 100 is disposed such that the upper and lower surfaces in a state of being mounted on the PCB 101 are reversed, and the side on which the terrace is located is the upper side in the height direction (z axis) of the optical module. The optical module is mounted such that the terrace surface faces the upper surface of the PCB, and in the case of the Tx module 400, heat from the driver IC and the Peltier element moves toward the side on which the terrace surface of the package is located (in the +z direction).

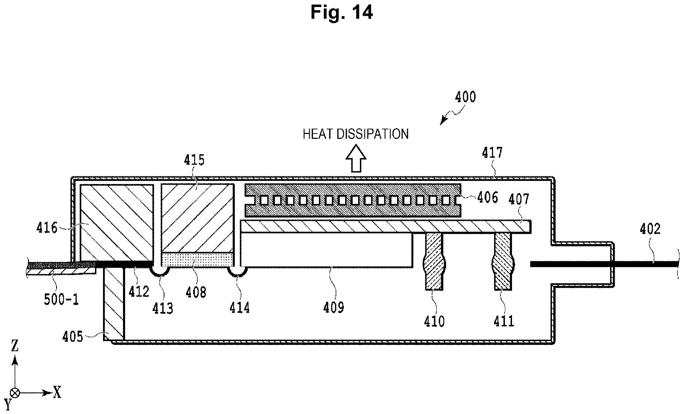

Fig. 14 is a view illustrating a cross-sectional structure in a Tx module in the optical transceiver of the present disclosure. It should be noted that in Fig. 14, the completed Tx module 400 is flipped upside down and its internal structure is illustrated in a state of being mounted on the optical transceiver 100. In the Tx module 400, a Peltier element 406, a circuit board 407, and an optical modulator chip 409 are disposed in this order inside a housing 417. On the circuit board, lenses 410 and 411 are included and optically coupled to an optical fiber 402. In the module, a driver IC 408 is formed on the surface of a base 415, and a wiring 412 is formed on a package base 416. Portions between the optical modulator chip 409 and the wiring 412 are connected by wires 413 and 414. The inside and the outside of the module are partitioned by the housing 417, the package base 416, and a package side wall 405. A terrace surface of the optical module is formed by a part of the package base 416 being exposed from the housing. An FPC 500-1 is connected to the terrace surface.

In a state where the Tx module is mounted on the PCB of the optical transceiver as illustrated in Fig. 14, the Peltier element 406 for temperature control and the base 415 thermally connected to the driver IC of a heat generating component are located on the inner surface of the housing 417 opposite to the PCB 101. A mechanism for heat dissipation from the inside of the Tx module is formed such that heat moves from the driver IC or the Peltier element to the outside in the +z direction. Also in the Rx module, a TIA is included instead of the driver IC, and heat from the inside of the Rx module moves to the upper side of the module (+z direction) in a state where the Rx module is mounted on the PCB 101.

As described above, the optical module is mounted on the PCB in a state in which a heat generating component inside the package can dissipate heat from the surface opposite to the mounting surface fixed to the PCB toward the outside of the package. Therefore, for heat dissipation from the DSP chip 202 and heat dissipation from the Tx module 400, a heat dissipation mechanism (housing) in which one common heat dissipation surface (not illustrated) is disposed on the upper side of the optical transceiver 100 can be adopted. The optical module and the DSP are disposed close to each other, and at the same time, the heights of DSP and the upper surface of the optical module are matched, so that heat dissipation of the DSP and the optical module can be easily performed by a single heat dissipation mechanism. In the case of a common heat dissipation mechanism, it is necessary to sufficiently consider that heat does not sneak from the DSP to the optical module. Furthermore, in order to reduce sneaking of heat via the heat dissipation mechanism, separate heat dissipation mechanisms on the same plane can be used for the DSP and the optical module.

The DSP 200 includes a DSP circuit board 201 including a multilayer wiring circuit board to be described below, the DSP chip 202, and a lid (cover) 203. The DSP chip 202 and the DSP circuit board 201 are connected by a BGA 204. Similarly, the DSP circuit board 201 and the PCB 101 are also connected by a BGA 205.

The lid 203 is formed from an integrated metal so as to cover at least the entire region of the upper surface of the DSP chip 202 and a region excluding a region to which FPCs 500-1 and 500-2 are connected and fixed on the upper surface of the DSP circuit board. The lid 203 may cover the side surface of the DSP chip 202 or may protrude from the periphery of the DSP circuit board 201. The lid 203 prevents unexpected damage from being directly applied to the DSP chip, BGAs 204 and 205 as connection portions, and the like due to a handling error or the like at the time when the DSP 200 is mounted on the optical transceiver or during a manufacturing process. By the shape of the lid 203 being finely contrived, the surface of the DSP circuit board 201 from the RF connection PAD for connection with the FPC to the circuit board end can be brought into an open state. As described above, the DSP 200 can be prepared as a DSP module in a state where the DSP chip 202 and the lid 302 are mounted on the DSP circuit board 201. Although a manufacturing process of the optical transceiver will be described below, if the DSP 200 is prepared as a form of a lidded DSP module, the DSP 200 can be safely mounted on the PCB 101 without damage caused in the manufacturing process, similarly to the Rx module and the Tx module.

As another form of the DSP 200, the DSP 200 can be prepared in a state where only the DSP chip 202 is mounted on the DSP circuit board without a lid. Alternatively, the DSP 200 without a lid and the optical modules 300 and 400 can be connected using the FPCs 500-1 and 500-2, respectively, and then the lid 203 can be finally attached. In a case where a lid is mounted, there may be a risk that an inadvertent force is applied to the FPC or the wiring of the FPC is short-circuited by the lid 203. Therefore, the PAD position of a region including the connection PAD on the upper surface of the DSP circuit board 201 and the shape of the lid need to be sufficiently optimized. Since the DSP chip and the DSP circuit board are exposed until immediately before the lid is mounted, careful attention needs to be paid so that the DSP chip and the like are not damaged.

In a case where the DSP 200 includes the lid 203, the footprint of the lid 203 is always smaller than the footprint of the DSP circuit board 201 on the circuit board surface (x-y surface). On the other hand, the footprint of the DSP chip 202 is included in the footprint of the lid. On the circuit board surface of the DSP circuit board 201, the lid 203 is not included only in a region where at least the RF connection PAD is included.

In the manufacturing process of the optical transceiver, if damage to the DSP chip and the BGAs 204 and 205 can be avoided, the lid can be omitted. In order to effectively release heat dissipated from the DSP chip to the outside of the optical transceiver, the lid may be simply included only on the upper surface of the DSP chip. The shape of the lid 203 can be variously modified, and specific variations will be described below.

The Rx module 300 and the Tx module 400 are each housed in a package. The two optical modules 300 and 400 and the DSP 200 are directly connected by the FPCs 500-1 and 500-2 as RF interfaces for electrical signals. Here, "directly" connected means that the connection PAD on the terrace of the optical module and the connection PAD on the DSP circuit board are connected only via the FPCs 500-1 and 500-2. Therefore, in the optical transceiver 100, there is no high frequency path through the VIA that is connected from the optical module to the PCB, the RF signal line in the PCB, the BGA that connects the PCB and the DSP circuit board, and the VIA in the DSP circuit board. In the optical transceiver 100, an electrical signal does not pass through the VIA or the BGA that leads to deterioration of high-frequency characteristics, as compared with an optical transceiver including an optical module of the SMT type package of the conventional art. The DSP and the optical module can be connected by the shortest high frequency path, and a high frequency loss can be greatly reduced. Furthermore, since the number of connection portions of the VIA, the BGA, and the like is reduced, the configuration of the optical transceiver of Fig. 2 is very effective also from the viewpoint of reducing a high frequency loss due to impedance mismatching that occurs at a discontinuous portion of the high frequency path.

Direct current (DC) interfaces of the optical modules 300 and 400 can be, for example, lead pins 301 and 401 as illustrated in (a) of Fig. 2. The DC interfaces are not limited to the lead pin structures, and FPCs may be used similarly to the RF interfaces with the DSP 200. The DC lead pins 301 and 401 are soldered to a PAD (not illustrated) of the PCB 101 such that power can be supplied from the outside of the optical transceiver.

Referring again to the top view of the optical transceiver 100 in (a) of Fig 2, the Rx module 300, the Tx module 400, and the DSP 200 are optimally disposed such that the loss of an RF signal that is a high-frequency electrical signal is minimized. The two modules and the DSP 200 are disposed symmetrically with respect to the center line along the longitudinal direction of the PCB 101. In order to implement a high-speed optical transceiver, reducing a high frequency loss of an RF signal from the DSP 200 to the Tx module and an RF signal from the Rx module to the DSP 200 is important. The length of each of the FPCs 500-1 and 500-2 that functions as an RF interface needs to be as short as possible. In the optical transceiver 100 of Fig. 2, in order to transmit a high speed signal of more than 128 GBd, a distance (gap) in the y-axis direction between the two optical modules is preferably brought close to 1 mm or less.

In order to dispose the two optical modules close to each other, the DC lead pins need to be collected on one sides of the respective modules and directed in opposite directions. As illustrated in (a) of Fig. 2, the DC lead pin 401 of the Tx module 400 is directed toward the outer periphery of the PCB 101 in the -y-axis direction (downward in the figure), and the DC lead pin 301 of the Rx module 300 is directed toward the outer periphery of the PCB 101 in the +y-axis direction (upward in the figure). This configuration follows the direction of a lead pin defined in the HB-CDM standardized by the OIF as described in Non Patent Literature 1.

The package of the optical module is formed from ceramic. Considering the layout design of a high-frequency signal line and a DC line in the optical module, the height from the upper surface of the PCB 101 to the terrace surface of the optical module in the cross-sectional view of (b) of Fig. 2 is desirably about 1 to 2 mm. The thickness of the DSP circuit board 201 is desirably similarly set in a range of about 1 to 2 mm from the viewpoint of matching the height with the terrace surface of the optical module. By the height of the upper surface of the DSP circuit board being matched with the height of the terrace surface, bending in the thickness direction of the FPC becomes unnecessary and the FPC is flattened as described below.

In a case where the DSP circuit board has a thickness of about 1 to 2 mm, more layers than necessary for the DC line and the RF line can be utilized. In general, in a multilayer wiring circuit board, the number of layers is desirably minimized as much as possible in terms of cost, and thus a core layer for adjusting the thickness of the entire circuit board can be used inside. The multilayer wiring circuit board including such a core layer may be referred to as a build-up circuit board. The core layer not only adjusts the entire circuit board thickness, but also functions as a separation layer that separates an RF wiring layer and a DC wiring layer. By the core layer being included, the DC layer and the RF wiring layer can be largely separated from each other, so that mutual interference between the wiring layers and an influence of noise can be reduced. A detailed configuration of the DSP circuit board will be described below together with detailed configurations of a PAD and a signal line.

In consideration of high-speed DSP operation as described above, the DSP 200 is desirably accommodated in the DSP circuit board 201 having a small size in order to reduce a loss and cost of a high-frequency signal. The two FPCs should be formed to converge on the center line of the DSP 200 from the optical module side toward the DSP side. As will be described below, both FPCs illustrated in Fig. 2 have a shape bent in a plane (x-y plane) of the base material, which is previously shaped into a predetermined shape. Although the FPCs can also be formed in a straight line shape without being bent, the PAD needs to be spread and arranged in a fan shape on the circuit board surface of the DSP circuit board 201. The high frequency loss on the DSP circuit board increases, and the size of the DSP circuit board also increases, which is not preferable.

### [Connection Form Between DSP and Optical Module of Optical Transceiver]

The optical transceiver 100 of the present disclosure includes one feature in a connection form of the FPC between the DSP and the optical module. In the optical transceiver 800 of the conventional art illustrated in Fig. 1, the FPC 806 is on a common surface of the circuit board surface of the DSP circuit board 804 and the terrace surface of the optical module 807 in the same direction, and is connected only by one surface of the FPC 806. On the other hand, in the optical transceiver 100 in (a) of Fig. 2, the FPC 500-1 is on a common surface of the circuit board surface of the DSP circuit board 201 and the terrace surface of the Tx module 400 in the opposite direction, and is connected by different surfaces of the FPC 500-1. The optical module 400 is mounted on the PCB 101 upside down from the conventional art such that the terrace surface including the connection PAD for the FPC faces the PCB 101 side.

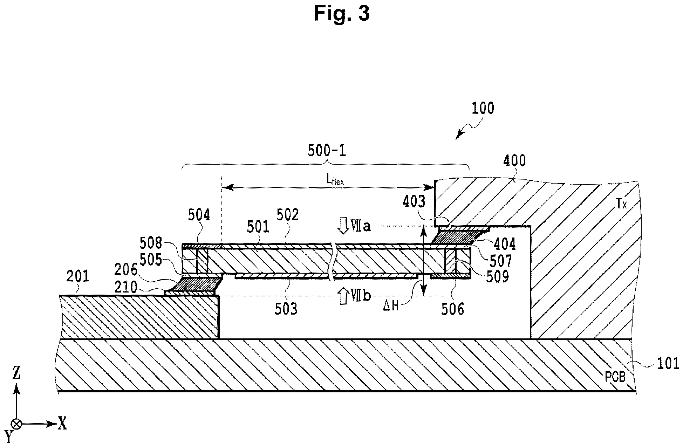

Fig. 3 is an enlarged cross-sectional view of an optical module including connection portions of the FPC. It is a side cross section (x-z plane) obtained by enlarging the vicinity of the FPC 500-1 of (b) of Fig. 2, and the height direction (z-axis direction) is enlarged and displayed. Furthermore, it should be noted that, in order to make the configuration in the vicinity of the FPC easy to understand, the relative size relationship of each part is not accurately drawn. Fig. 3 and (b) of Fig. 2 are cross-sectional views taken along a line IIb-IIb in (a) of Fig. 2 and perpendicular to the PCB surface, and the line crosses the signal line of the bent FPC 500-1, but assume that Fig. 3 and(b) of Fig. 2 are illustrated along the signal line in the FPC. In the optical transceiver 100 of the present disclosure, in order to reduce the high frequency loss caused by bending the FPC in the thickness direction (z-axis direction), a configuration that minimizes the FPC bending is adopted.

Fig. 3 illustrates the FPC 500-1 that connects the connection PAD 210 at the end portion of the DSP circuit board 201 and the connection PAD 403 on the terrace surface of the Tx module 400. In the FPC 500-1, metal layers are formed on both surfaces of a base material 501, and a signal line 502 is included on the upper side of the drawing, and a ground (GND) surface 503 is included on the opposite side. A PAD 504 and a connection PAD 507 for an optical module are formed at both ends of the signal line 502. A connection PAD 505 for the DSP connected to the PAD 504 by the VIA or a through hole 508 and a PAD 506 connected to the connection PAD 507 via the VIA or a through hole 509 are also formed on the GND surface side. As described below, by the PAD 504 being heated, the connection PAD 505 and the connection PAD 210 are connected by solder 206. Similarly, by the PAD 506 being heated, the connection PAD 507 and the connection PAD 403 are connected by solder 404.

In the optical module 100 of the present disclosure, in order to minimize bending in the thickness direction of the FPC, a difference ΔH in height between the terrace surface of the Tx module and the upper surface of the DSP circuit board 201 is set to 500 µm or less. If the height difference is up to about 500 µm, the FPC does not need to be bent largely in the thickness direction, and the FPC can be connected almost flat. The high frequency loss due to large bending of the FPC and a risk of cracking of metal wiring on the FPC are reduced, and good high frequency connection can be implemented.

The base material 501 of the FPC is generally easier to handle as the base material is thinner since the shape in the height direction can be flexibly adjusted in the mounting process. On the other hand, in terms of high frequency characteristics, the base material is preferably thick in order to reduce the loss. In consideration of these, the thickness of the base material 501 is desirably, for example, 50 µm or more. Specifically, if the base material 501 has a thickness of about 50 to 100 µm, mounting can be easily performed by the shape of the FPC in the thickness direction being slightly adjusted even if the height difference ΔH between the terrace surface and the DSP circuit board surface described above is about 500 µm. In a case where ΔH is set to about 500 µm, damage to solder joints between the FPC and the optical module can also be reduced in the mounting process. In a case where solder 206 and 404 in the finished state of solder connection portions at both ends of the FPC is thick, the size of a conductor portion of a transmission line changes, and characteristic impedance of a signal line may decrease. The solder thickness between the PADs is desirably 50 µm or less.

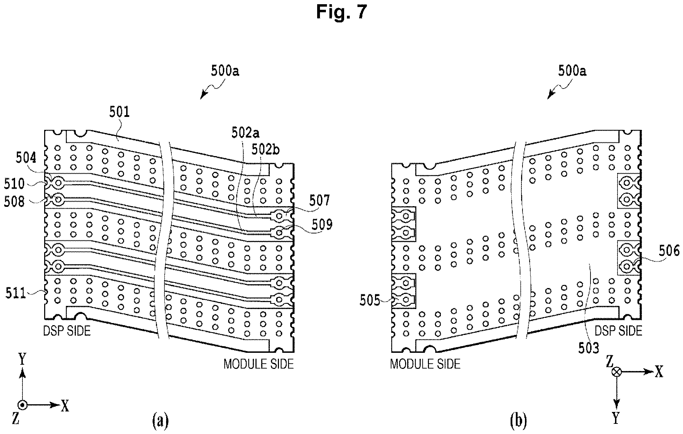

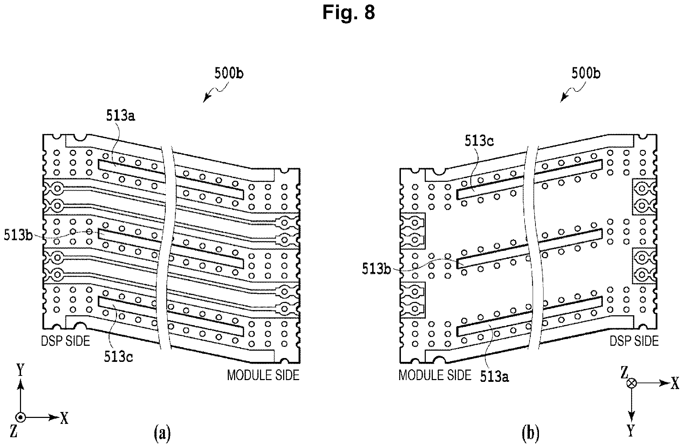

As described above, it is advantageous in terms of high frequency characteristics that the length of the FPC 500-1 is as short as possible. In practice, the influence of heat from the DSP chip 202, which is the largest heat source at the optical transceiver, must be considered. If the optical module 300, 400 and the DSP chip 202 are brought too close to each other, the optical module may have a very high temperature. In a case where the optical module includes the Peltier element, there is a risk that the power consumption of the Peltier element greatly increases, or the Peltier element becomes inoperable to cause thermal runaway. Furthermore, if the FPC is too short, in the process of connecting the FPC to the DSP circuit board, there arises an issue that a portion for holding the FPC disappears or a length for bending the FPC cannot be secured. From the viewpoint of thermal design and mountability, the length of the FPC is preferably 3 mm or more. The wiring layout of the FPC will be described below together with Figs. 7 and 8.

### [Outline of Procedure for Assembling Optical Transceiver]

An outline of a mounting procedure of the optical transceiver 100 will be described. The Rx module 300 and the Tx module 400 are in a state in which the FPCs are solder-connected to the respective terrace surfaces in advance. First, the DSP 200 is mounted on the PCB 101 by reflow, and then the optical modules 300 and 400 are mounted on the PCB 101. The reason why the optical modules and the DSP are separately mounted is that passing the optical modules through a normal reflow process is difficult due to restriction of heat resistance or the like.

First, in the optical modules 300 and 400, the respective FPCs are solder-connected to the connection PAD 210 of the DSP 200. Then, the lead pins 301 and 401 of the optical modules are fixed on the PCB 101. Since the FPCs of the optical modules are RF interfaces, the size of the connection PAD 505 has a limit for impedance matching. High frequency transmission characteristics and connection strength are affected by positional deviation between PADs that face each other via solder, and therefore mounting of an optical module including an FPC needs to be performed with very high accuracy. On the other hand, since it is sufficient that the lead pins are reliably connected in terms of direct current, the DC PAD size on the PCB side can be increased, and the allowable error of the positional deviation may be relatively large. Therefore, the optical modules are connected from the FPC side, and then the lead pins are connected.

In order to reduce the number of processes in mounting the FPCs on the DSP 200 mounted on the PCB, the Tx module and the Rx module are desirably heated and soldered collectively using a hot bar. In order to perform mounting by the hot bar, pre-solder processing needs to be performed on at least one of the connection PAD 505 of the FPC or the connection PAD 210 on the DSP circuit board in advance. At least one via (VIA) 508 is required as illustrated in Fig. 3 in order to melt the pre-solder between the connection PADs by the hot bar and perform solder-connecting. By the hot bar being pressed against the heating PAD 504 from above in Fig. 3, the VIA 508 transfers the heat of the heating PAD 504 to the solder 206 between the connection PADs 505 and 210. On the other hand, the VIA 508 may be a through hole instead of the VIA. Here, the through hole refers to a hole that penetrates the circuit board, and an inner surface and the like of the hole are all metallized. In the case of the through hole, since solder can flow through the hole, pre-solder processing only needs to be performed on at least one of the connection PAD 505 of the FPC, the heating PAD 504, or the connection PAD 210 on the DSP circuit board.

The lead pins 301 and 401 of the optical modules are DC interfaces, and only need to be electrically connected, and thus slight deviation or the like is allowed. The PAD size on the PCB can also be set sufficiently wide with respect to the lead pins, and high-precision alignment and a mounting method such as those on the FPC side are not required. The lead pins cannot be bent after being fixed, but the FPCs can be bent to some extent. Therefore, after the FPCs are fixed first, the FPCs can be finely adjusted for connection and fixing of the DC lead pins.

### [Variation of Lid Configuration]

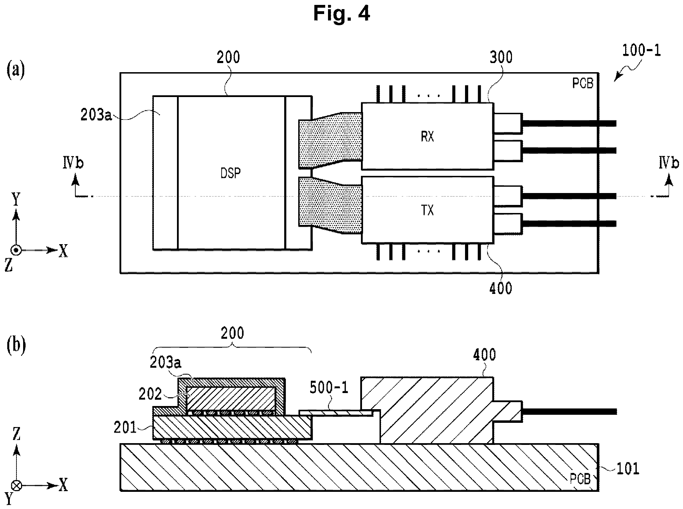

Fig. 4 is a view illustrating another configuration example 2 of a DSP lid of the optical transceiver of the present disclosure. An optical transceiver 100-1 is an example in which only the lid shape of the optical transceiver 100 in Fig. 2 is changed. A lid 203a covers a portion up to the side surface of the DSP chip 202 on the FPC side.

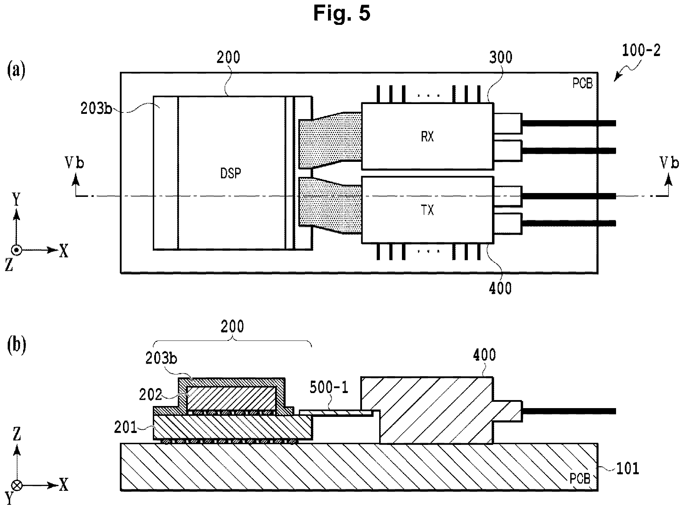

Fig. 5 is a view illustrating another configuration example 3 of the DSP lid of the optical transceiver of the present disclosure. An optical transceiver 100-2 is an example in which the lid shape of the optical transceiver 100-1 in Fig. 4 is further changed. A lid 203b is further extended from the side surface on the FPC side of the DSP chip 202 to the vicinity of the connection PAD for the FPC as closely as possible.

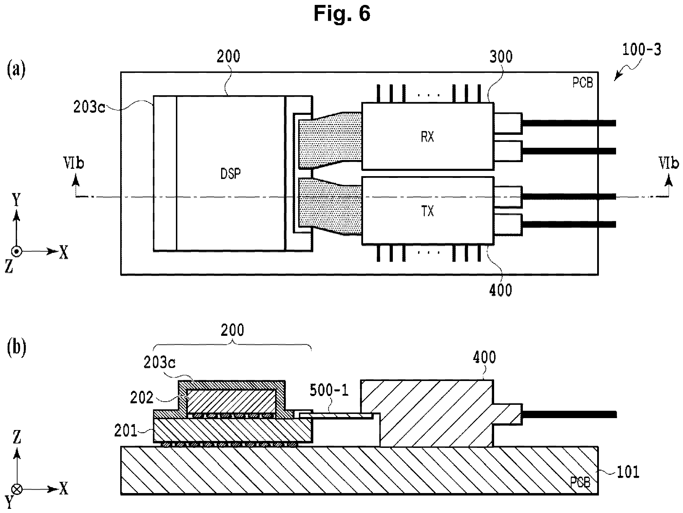

Fig. 6 is a view illustrating another configuration example 4 of the DSP lid of the optical transceiver of the present disclosure. An optical transceiver 100-3 is an example in which the lid shape of the optical transceiver 100-2 in Fig. 5 is further changed. A lid 203c surrounds three sides of a region of the connection PAD on the upper surface of the DSP chip 202.

As described above, the shape of the lid can be variously varied, and the shape and footprint may be any shape and footprint as long as heat generated from the DSP chip 202 can be efficiently transmitted to the outside. The lids 203, 203a to 203c only need to cover a region including at least a region of the DSP chip 202 and excluding the connection PAD of the DSP circuit board on the mounting surface (x-y surface) for the PCB. A small lid that covers only the upper surface of the DSP chip can also be used. The lid is connected to the DSP chip using an appropriate adhesive having thermal conductivity or the like, and dissipates heat to a heat dissipation mechanism outside the optical transceiver.

### [Wiring Layout of FPC]

Here, a more specific configuration of the FPC in the optical transceiver 100 of the present disclosure will be described. As illustrated in Fig. 3, the FPC has a structure in which metal layers are included on both surfaces of the base material 501, the signal line 502 of the high frequency transmission line is included on one surface, and the GND surface 503 for the signal line is included on the other surface. The FPC is desirably formed such that the surface on which the signal line 502 is located faces the terrace surface of the Tx module 400. Conversely, in a case where the FPC is formed such that the signal line 502 faces the circuit board surface of the lower PCB 101, the metal wiring pattern on the PCB and the signal line 502 on the FPC may interfere with each other. Due to the influence of this interference, there is a risk of deterioration of high-frequency transmission characteristics of an electrical signal input and output between the DSP 200 and the optical module, mixing of noise between an electrical signal and a DC signal on the PCB, and the like. As illustrated in Fig. 3, in a case where the GND surface 503 of the FPC 500-1 faces the PCB 101 side, the above-described interference issue does not occur. However, in a case where there is no electric wiring or other components on the PCB 101, or in a case where a sufficient distance can be taken between the PCB and the FPC, the surface of the signal line of the FPC and the GND surface may be turned upside down from those in Fig. 3.

Fig. 7 is a view illustrating an FPC wiring layout in the optical transceiver of the present disclosure. (a) of Fig. 7 illustrates a first surface (x-y surface) on a side where the signal line is located, and (b) illustrates a second surface side (x-y surface) opposite to the first surface and including the GND surface. In Fig. 7, the cover lay and the resist of the FPC are omitted in order to make the layout easily viewable. On the first surface side of an FPC 500a in (a) of Fig. 7, for example, two sets of signal lines 502a and 502b in a ground-signal-signal-ground (GSSG) differential format are illustrated. Here, G represents ground, and S represents a signal. The number of sets of signal lines may vary depending on the type of optical module. Furthermore, the area of the PAD on the GND surface is made larger than that of the PAD for a signal line. From the viewpoint of high frequency characteristics, a smaller PAD size of the PAD for a signal line is more desirable, but a sufficient area for solder connection is required for securing connection strength by solder. Therefore, the connection strength of the solder can be secured by the PAD on the GND side being made sufficiently wider than the signal line PAD.

The maximum area of the GND PAD between channels is uniquely determined by an inter-channel pitch by the signal line PAD on the FPC and the DSP circuit board. In a case where the inter-channel pitch is narrow and the area for the GND PAD cannot be sufficiently secured, increasing the size of the GND PAD at both ends in the width direction (y direction) of the FPC is effective. Since there is a risk of short-circuiting in a case where solder flows in a region other than the PDA region to be soldered, a region that requires no solder in the FPC is covered with a resist. It should be noted that the GND PAD is also defined for the GND surface by the PAD region to be soldered being partitioned by the resist. Therefore, a plurality of PADs is disposed in the GSSG differential format at the end portion of the FPC. Furthermore, since application of the resist to a signal line leads to an increase in high frequency loss, the area of the resist needs to be made as small as possible.

The GND surface 503 for the signal lines 502a and 502b is formed on the second surface side of the lower surface of the FPC 500a in (b) of Fig. 7. As illustrated in the cross-sectional view of the FPC connection portions in Fig. 3, the first surface of the FPC including the signal line 502 is connected to the connection PAD of the terrace surface of the optical module 400, and the second surface of the FPC including the GND surface 503 is connected to the connection PAD of the upper surface of the DSP circuit board 201. Each of the first surface and the second surface of the FPC will be utilized for the RF interface. Therefore, the VIA 508 included in the path of the signal line 502 plays an important role not only as a fixing function by solder but also as a part of a signal path for transmitting a high-frequency signal.

In order to transmit a high-frequency signal without a loss, if the VIA is not disposed at the edge of the PAD portion, a partial region of the PAD away from the VIA forms an open stub, and capacitive impedance is added to the signal line. In order to prevent this, as illustrated in Fig. 7, a half-through hole 510 is included in the endmost portion of the FPC 500a for the signal lines 502a and 502b. In a case where the PAD length is sufficiently short and an impedance change due to stub formation is not an issue in the used frequency band, the half-through hole is not essential. Similarly, in order to stabilize the high-frequency potential on the GND surface, a half-through hole 511 is included in the endmost portion of the FPC 500a. The half-through holes 510 and 511 not only improve the high frequency characteristics but also lead to formation of a fillet of solder in the connection PAD, and thus help to enhance the solder connection strength. With respect to the half-through hole 510 for the PAD of the signal line, in a case where the half-through hole diameter is too large and the surrounding land area is large, the capacitance at the PAD portion increases, leading to a decrease in impedance of the connection PAD and deterioration of high-frequency characteristics. In order to reduce deterioration of the high frequency transmission characteristics in a signal line, a diameter ϕ of the half-through hole 510 is desirably 150 µm or less.

The configuration of the connection PAD and the like of the DSP circuit board 101 will be described below, but from the viewpoint of fillet formation of the FPC end portion, mounting is desirably performed such that positions of the PAD end of the signal line of the FPC and the PAD end of the signal line on the DSP circuit board are shifted from each other by about 100 µm.This corresponds to the fact that the end portion of the connection PAD 210 on the DSP circuit board is shifted in the -x direction as compared with the end portion of the connection PAD 505 in Fig. 3. By the size and positional relationship of the connection PADs 505 and 210 being set in this way, a favorable fillet is formed in the solder 206 of the connection portion, and the strength quality of the solder can be improved. Specifically, the connection PADs 505 and 210 are set to have the same length, and mounting can be performed by the FPC position being adjusted such that the edge positions of the two PADs are shifted in the length direction (x direction). Further, as in the cross-sectional view illustrated in Fig. 3, edges on one sides of the connection PADs 505 and 210 may be aligned, and the length of the connection PAD 505 on the FPC side may be shorter than that of the connection PAD 210 on the DSP circuit board 201 by about 100 µm. Since the half-through hole 511 at the end portion of the GND surface does not significantly affect the high frequency characteristics, the half-through hole may be a half-through hole having a large diameter according to required connection strength.

Fig. 8 is a view illustrating another configuration example of the FPC in the optical transceiver of the present disclosure. A configuration difference between the FPC 500b and the FPC 500a illustrated in Fig. 7 is that voids 513a to 513c are included in the region of the GND surface. In general, as the number of ground VIAs is larger and the base material 501 of the FPC is thicker, the FPC is harder and the bendability is deteriorated. In order to maintain the flexibility of the FPC and secure the bendability, including the voids 513a to 513c in the region of the GND surface is effective. Since the voids reduce the area of the metal region on the GND surface, the stability of the ground potential and the crosstalk between channels may be deteriorated. As described above, in a case where the FPC does not need high bendability, the voids do not need to be included. In a case where the FPC can be mounted in a flat form with almost no bending in the thickness direction as in the optical transceiver 100 of the present disclosure, not including the voids in the FPC is preferable from the viewpoint of high frequency transmission characteristics.

Although the ground VIAs are desirably reduced as described above from the viewpoint of securing the bendability of the FPC, the effect of ground in a high frequency band is reduced in a case where the VIA density is reduced, and the high frequency transmission characteristics are caused to be deteriorated. In order to prevent deterioration of transmission characteristics in a high frequency range within a required frequency band of an electrical signal input to and output from the DSP, the interval between the VIAs should be controlled. On the GND surface of the FPC, the VIAs need to be disposed at intervals of 1/4 or less of the wavelength in the transmission line at the maximum frequency of the required transmission band of an electrical signal input to and output from the DSP 200.

### [Configuration of PAD on DSP Circuit Board]

Hereinafter, examples of the configuration of the connection PAD for the FPC, the configuration of the signal line, and the internal configuration of the circuit board in the DSP circuit board 201 of the optical transceiver 100 will be described. Although only two sets of signal lines are illustrated in the drawings in the following description, a connection PAD for a plurality of signal lines and a GND PAD of which the region is defined by a resist on the GND surface are disposed along an end portion on one side of the DSP circuit board 201. The PAD of the FPC and the PAD on the DSP circuit board correspond one-to-one.

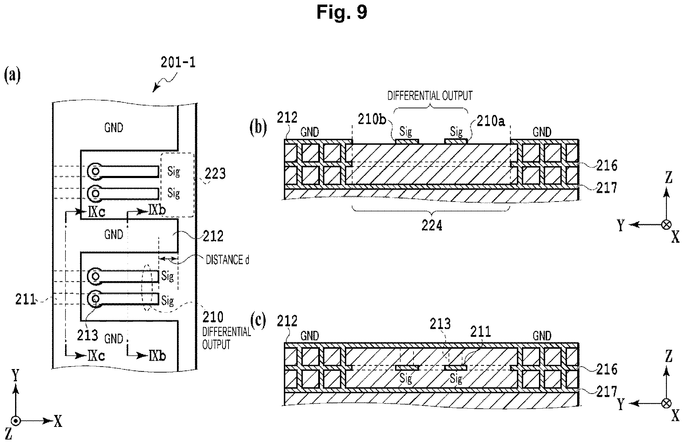

Fig. 9 is a view illustrating a configuration of a signal line and an internal layer structure in a DSP circuit board. (a) of Fig. 9 is a top view (x-y plane) illustrating an electrode configuration of an end portion of a DSP circuit board 201-1 solder-connected to the FPC. (b) of Fig. 9 is a cross-sectional view (y-z plane) obtained by vertically cutting the DSP circuit board 201-1 along a line IXb-IXb, and illustrates the connection PAD 210 of the signal line of the differential format. (c) of Fig. 9 illustrates a signal line 211 of the inner layer in a cross-sectional view (y-z plane) obtained by vertically cutting the DSP circuit board 201-1 along a line IXc-IXc. Fig. 9 illustrates an example using two dielectric layers, and only one dielectric layer can be used, or three or more dielectric layers can be used.

A large number of DC lines and RF signal lines for operating the DSP chip are formed on the DSP circuit board. Since interference between the DC lines and the RF signal lines need to be reduced, formation using a so-called build-up circuit board having a multilayer structure is desirable. The build-up circuit board is a printed circuit board formed (built-up) by a metal layer and a dielectric layer being sequentially laminated one by one on a circuit board that serves as a core. A laser via (non-penetrating VIA) is formed in the build-up layer. Unlike a general penetrating VIA, since the laser via does not penetrate between layers, high-density wiring can be implemented. Furthermore, the penetrating VIA is formed by drilling using a drill, whereas the laser via is processed using a laser. Therefore, a build-up circuit board that is including a via having a small diameter can be manufactured with high accuracy, and a very precise pattern such as narrow pitch fine wiring can be formed.

In order to handle high-speed electrical signals of class 128 GBd or more in a DSP circuit board, a VIA having a small diameter is essential, and a build-up circuit board in which a VIA having a diameter of 100 µm or less can be formed is required. From the viewpoint of an aspect ratio in VIA processing at the time of manufacturing a circuit board, in an RF wiring layer in which a VIA diameter of 100 µm or less is required, the thickness of each dielectric layer needs to be 100 µm or less.

The connection PAD of the differential signal line 210 illustrated in (a) and (b) of Fig. 9 needs to be as small as possible and sufficiently separated from the GND surface of a lower GND layer 217 from the viewpoint of impedance matching in a connection state with the connection PAD 505 of the FPC illustrated in Fig. 7 via solder. Specifically, the relative permittivity of the build-up circuit board is assumed to be about 3.0 to 3.5, and the solder thickness of the connection portion is assumed to be about 50 µm. Assuming connection with characteristic impedance of 100 Ω, the width (y direction) of connection PADs 210a and 210b of the signal line is desirably 0.2 mm or less, the length (x direction) is desirably 1 mm or less, and the GND surface of the lower GND layer 217 is desirably separated by at least 0.1 mm or more. Similarly, the distance (y direction) between an adjacent ground PAD 212 of the outermost layer and each of the connection PADs 210a and 210b also needs to be 100 µm or more.

In Fig. 9, differential signal lines for two channels are exemplarily illustrated across the GND surface. In order to maintain the solder connection strength in the PAD portion and the crosstalk between the channels, greatly increasing the distance (y direction) between the connection PADs and the GND PAD is difficult. This is because, in a case where the connection PADs of the signal line are formed at a constant pitch between adjacent channels, widening the distance between the connection PADs and the GND PAD reduces the area of the GND PAD portion. Implementing solder connection between the FPC and the DSP in a state where impedance matching is good without deterioration of solder connection strength and inter-channel crosstalk is required. Therefore, adjusting the distance between the connection PADs 210a and 201b and the GND surface of the lower GND layer 217 is useful. From this viewpoint, a thickness direction distance (z direction) between the connection PADs and the GND surface of the GND layer 217 is desirably larger than a width direction distance (y direction) between the GND PAD of the outermost layer and the connection PADs.

Furthermore, even if the distance (z direction) of the lower GND surface is sufficient, in a case where an intermediate layer 216 in the middle is closer to the signal line side than the ground metal of the outermost layer, the impedance is reduced by the close ground. Therefore, referring to the y-z cross section in (b) of Fig. 9, formation needs to be performed such that the GDN of the intermediate layer 216 does not protrude on the inner side of the adjacent ground surface (ground PAD) 212 of the outermost layer, that is, a region 224 on the signal line side. That is, the connection PAD 210 is formed not to include another metal conductor in a region between the adjacent ground PADs 212 in a cross section perpendicular to the longitudinal direction (x direction), the region being in a range of at least 0.1 mm or more in the circuit board thickness direction.

Considering the connection strength with the FPC and the mountability, the widths of the connection PADs 210a and 210b of the signal line are desirably at least 100 µm or more. This is because, in a case where the connection PAD width on the DSP circuit board is 100 µm or less, there is a risk that solder connection cannot be successfully performed in a case where a positional deviation at the time of mounting the FPC or a width tolerance or a positional tolerance of the connection PAD on the DSP circuit board side or the FPC side is accumulated.

An interval (y-axis direction) between the signal lines is also important from the viewpoint of impedance matching, and for example, in the case of the GSSG configuration as illustrated in Fig. 9, a distance between the signal lines of 0.3 mm or more needs to be kept. If the distance between the signal lines is too short, a risk of short-circuiting between the signal lines occurs at the time of solder mounting. If the distance between the signal lines of 0.3 mm or more can be set, even if the width of the connection PADs 210a and 210b of the signal lines is 200 µm, the distance between the edges of the signal lines can be secured to be 0.1 mm. A resist is disposed between the signal lines, and occurrence of short-circuiting due to solder mounting can be reduced. Also in terms of characteristic impedance design, since bringing the signal lines close to each other leads to low impedance, securing a distance between the signal lines of 0.3 mm or more is very important. Furthermore, in a case where the capacity of the connection portion increases, the cutoff frequency of the transmission frequency band decreases. In order to avoid such deterioration of the transmission frequency characteristics, the length and width of the connection PAD in the DSP circuit board are desirably as small as possible within a range in which both the connection strength and the mountability are secured.

In order to lower the capacity while securing the connection strength of solder, only one of the connection PAD of the DSP circuit board and the connection PAD of the FPC is preferably reduced. For example, the widths of the connection PADs 210a and 201b on the DSP circuit board side are set to 100 µm, and the width of the connection PAD on the FPC side is set to 200 µm. As a result, the capacity of the connection portion can be reduced while the mountability is secured. In the optical transceiver 100 of the present disclosure, the FPC is mounted by the heating PAD being heated by the hot bar from the FPC side. Therefore, in consideration of thermal conductivity and the like, the widths of the connection PADs 210a and 210b on the DSP circuit board side are desirably narrowed. Characteristic impedance of 100 Ω is assumed in the example of the PAD width described above, and if the signal line is designed using other impedance, there may be another optimum value.

An unintended combination between adjacent channels is said to be crosstalk, and a high-frequency signal input to and output from the DSP 200 gives interference to a signal of another channel, thereby deteriorating signal quality. In order to improve the high-frequency crosstalk characteristics between different channels, the GND pattern shape around the connection PAD 210 of the signal line is very important as illustrated in (a) of Fig. 9. Specifically, it is essential that the GND pattern is formed on the inner side of the circuit board such that a distance d from the edge on the circuit board end side of the ground PAD 212 on the DSP circuit board 201-1 to the edge on the circuit board end side of the connection PAD 210 of the signal line is 0.1 mm or more in the PAD length direction (-x direction). At the same time, it is also important that no ground metal is formed in a region 223 indicated by a dotted line on the circuit board end side (right side in the drawing) with respect to the connection PAD 210 of the signal line.

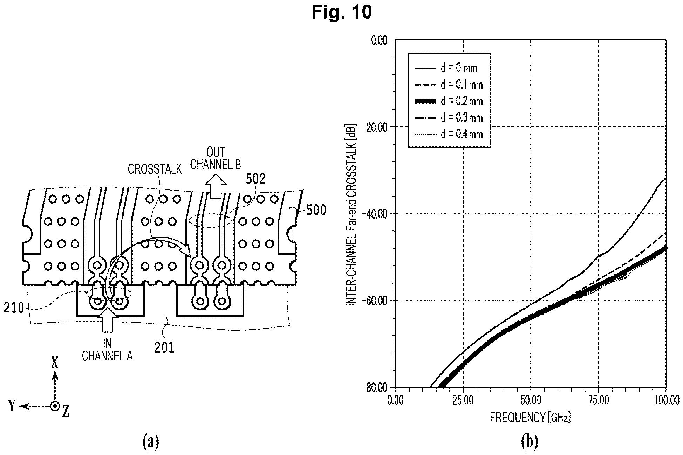

Fig. 10 is a diagram illustrating a simulation calculation result of inter-channel crosstalk. (a) of Fig. 10 illustrates the definition of a simulation model and Far-end crosstalk. (b) of Fig. 10 illustrates a calculation result of the inter-channel Far-end crosstalk frequency characteristics obtained by actually performing a simulation. "Inter-channel Far-end crosstalk" (hereinafter referred to as crosstalk) indicates a strength ratio of a signal transmitted from one differential pair at the near end to another adjacent differential pair at the far end in two adjacent channels with the GND PAD interposed therebetween. For an electrical signal of the target channels, an electrical signal that appears in another adjacent channel is unnecessary noise, and a smaller crosstalk value is more desirable. In this simulation, as illustrated in (a) of Fig. 10, the amount of an electrical signal input from the DSP PAD 210 that appears on the high frequency line 502 on the FPC side of the adjacent channel is illustrated. The simulation of the crosstalk value was performed in a range of d = 0.0 to 0.4 mm at intervals of 0.1 mm using the distance d between the edge of the GND PAD 212 on the DSP circuit board end portion side and the edge of the connection PAD of the signal line as a parameter.

From the calculation result of Fig. 10, it can be seen that in a case where the edge-to-edge distance d is 0.1 mm or more, a sufficient amount of crosstalk is stably obtained. Conversely, in a case where the edge-to-edge distance d = 0 mm is satisfied and the edge of the GND PAD 212 and the edge of the connection PAD 210 are matched, an increase in crosstalk of 20 dB or more is observed around 100 GHz. By the edge-to-edge distance d to 0.1 mm being set and the edge of the GND PAD 212 being relatively extended to the DSP circuit board end side, the crosstalk characteristics are significantly improved. Further, it can be confirmed that the crosstalk characteristics at 60 GHz or more are further improved by the edge-to-edge distance d to 0.2 mm or more being set. On the other hand, even if the edge-to-edge distance d is increased to 0.3 mm or more, no further improvement effect is obtained in the frequency band up to 100 GHz. Therefore, for example, if the specification is a specification in which the required transmission band is up to about 100 GHz, the edge-to-edge distance d may be about 0.1 to 0.3 mm.

### [Configuration of Signal Line on DSP Circuit Board]

In the above description, the configuration related to the connection PAD that is a connection portion of the DSP circuit board with the FPC has been described. Hereinafter, the structure of radio frequency (RF) wiring from the connection PAD toward the DSP chip will be described.

As illustrated in Fig. 2, in the optical transceiver 100, the lid 203 may be formed on the outermost layer portion of the DSP circuit board 201, or an underfill material or the like for the BGA 204 that connects the DSP chip 202 and the DSP circuit board may spill over. For this reason, in a case where the wiring is formed on the outermost layer of the DSP circuit board 201, there is a possibility that the characteristic values of the optical transmitter and the optical receiver vary between channels or the high frequency characteristics are greatly deteriorated depending on the conditions of the lid and the underfill material. In the optical transceiver 100 of the present disclosure, in order to eliminate the influence of the lid and the underfill material on the high frequency characteristics, a high frequency line other than the PAD portion that is essential for connection with the FPC is formed as an inner layer wiring.

Referring again to (a) and (c) of Figs. 9, the connection PAD 210 of the signal line is connected to the DSP chip as the signal line 211 of the inner layer via the VIA 213. In a case where the signal line is an inner layer wiring in the DSP circuit board 201-1 and the upper and lower sides of the signal line 211 are surrounded by the metal ground layers 212 and 217, the above-described lid and underfill material do not affect the high frequency characteristics.

Therefore, an optical transceiver of the present invention is an optical transceiver including: at least one optical module 300, 400 mounted on a printed circuit board (PCB) 101; a digital signal processor (DSP) 200 mounted on the PCB; and a flexible wiring board (flexible printed circuit [FPC]) 500-1, 500-2 that connects the DSP and the optical module, and implementation can be performed assuming that the DSP includes a DSP chip 202 mounted on a DSP circuit board 201, the FPC includes a first connection PAD 507 of a first surface solder-connected to a PAD of a terrace surface of the optical module and a second connection PAD 505 of a second surface solder-connected to a PAD 210 of an upper surface of the DSP circuit board, and the PAD of the DSP circuit board is connected to the DSP chip by a signal line 211 of an inner layer of a multilayer wiring circuit board from the PAD on the DSP circuit board via a via (VIA) 213.

In Fig. 9, as the simplest configuration example of the multilayer wiring circuit board, the configuration in which two dielectric layers having the same thickness are included on the surface layer side of the build-up circuit board is illustrated, but the layer thickness can be changed or the number of layers can be increased. In order to form a high frequency line by such an inner layer wiring, at least three metal layers of the upper surface ground layer 212, the signal line layer 216, and the lower surface ground layer 217 are essential. Furthermore, in Fig. 9, only two dielectric layers from the surface and three metal layers are illustrated in order to describe the configurations of the connection PAD 210 and the signal line 211 of the inner layer. In the DSP circuit board as the multilayer wiring circuit board, the configuration below the lower surface ground layer 217 is any configuration. Furthermore, Fig. 9 illustrates an example in which the VIA 213 connected to the inner layer wiring is included at the end of the connection PAD 210 on the DSP chip side, and transferred to the signal line. The present invention is not limited to this configuration, and a signal line based on the original characteristic impedance may be formed in a certain length on the front layer of the connection PAD 210, and then may be transferred to the inner layer via the VIA. Conversely, the VIA 213 may be present in the connection PAD 210. Note that a branch structure is not formed as the signal line, and attention is paid not to generate an open stub similarly to the case of the FPC.

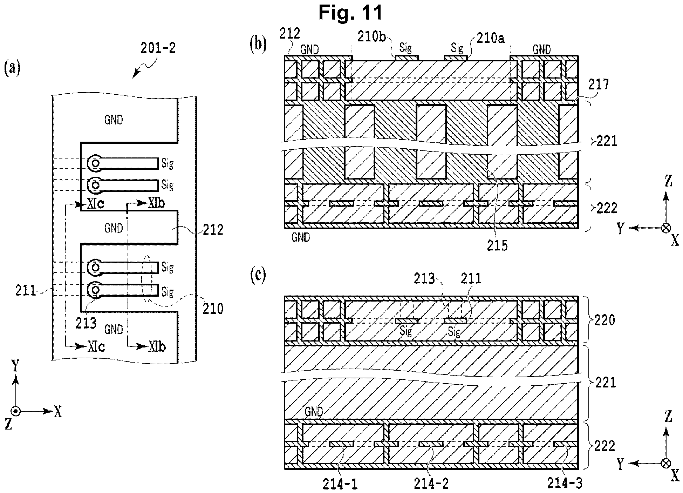

Fig. 11 is a diagram illustrating a configuration of a signal line in a multilayer wiring DSP circuit board including a core layer.

(a) of Fig. 11 is a top view (x-y plane) illustrating an electrode configuration of an end portion of a DSP circuit board 201-2 solder-connected to the FPC. (b) of Fig. 11 is a cross-sectional view (y-z plane) obtained by vertically cutting the DSP circuit board along a line XIb-XIb, and illustrates the connection PAD of the signal line. (c) of Fig. 11 illustrates the signal line of the inner layer in a cross-sectional view (y-z plane) obtained by vertically cutting the DSP circuit board along a line XIc-XIc. Fig. 11 illustrates a configuration example in which the number of layers of the multilayer wiring circuit board is increased and DC lines are also included as compared with the configuration of Fig. 9 illustrating only the surface layer. The connection PAD 210 in the top view of (a) of Fig. 11 is similar to Fig. 9, and in the cross-sectional views of (b) and (c), a core layer 221 and a DC wiring layer 222 are newly illustrated.

As described in Fig. 2, considering that the FPC is flattened in the thickness direction and the optical module and the DSP circuit board are connected with a low loss, the thickness of the DSP circuit board needs to be about 1 to 2 mm. In order to adjust the thickness of the circuit board, a core layer can be used in the multilayer wiring circuit board. As described above, the multilayer circuit board structure including this core layer is generally referred to as a build-up circuit board. In a case where the FPC is mounted on the DSP circuit board, the hot bar is pressed to apply pressure to the periphery of the connection PAD of the DSP circuit board. Depending on the mounting conditions of the FPC, the DSP circuit board may be damaged by an excessive pressure. Therefore, a DSP circuit board configuration capable of withstanding the pressure by the hot bar at the time of FPC mounting needs to be adopted.

As illustrated in (b) of Fig. 11, a plurality of large VIAs 215 is disposed in the core layer 221 immediately below the connection PADs 210a and 210b. The VIAs 215 in the core layer 221 increase the strength of the DSP circuit board in the connection PAD, thereby preventing deterioration of signal quality and reliability due to warpage or damage of the DSP circuit board caused by pressure by the hot bar. Since the core layer 221 does not affect high frequency characteristics, the diameter ϕ of the VIAs 215 does not need to be fine like 100 µm or less. Since there is a possibility that VIAs having a diameter ϕ of 100 µm cannot be formed depending on the thickness of the core layer 221, large VIAs having a larger diameter ϕ of about 200 µm to 300 µm or an even larger diameter can be used. Since the core layer 221 in (b) of Fig. 11 is a core layer of the build-up circuit board, embedded penetrating VIAs are generally illustrated.

In a case where DC lines and the like for operating the DSP chip are laid out around the connection PAD or the signal line of the inner layer, deterioration of high-frequency transmission characteristics due to mutual interference between the DC lines and the signal lines needs to be reduced. As illustrated in (c) of Fig. 11, DC lines 214-1 to 214-3 are desirably laid out in the DC wiring layer 222 below the ground layer 217 for the connection PAD and the ground layer 217 for the inner signal line 211. Since the DC wiring layer 222 is also sandwiched by ground layers on the upper and lower sides, interference with the signal line 211 of an RF wiring layer 220 can be completely eliminated. As described above, in the RF wiring layer 220, the three metal layers of the connection PAD 210 (upper surface ground layer), the signal line of the inner layer, and the lower surface ground layer for the signal line are essential. In order to further include DC lines in the DSP circuit board for electric wiring, at least four or more metal layers are required. From the viewpoint of high frequency design, similarly to the connection PAD, adjusting the layer thickness and the number of layers is important for the signal line of the inner layer. Although the DC wiring layer 222 is included, and the DC lines 214-1 to 214-3 by the fourth metal layer are illustrated in Fig. 11, there is no limitation on a layer that forms the DC lines in a region where a high frequency line does not exist in a range in which a high-frequency signal can exert an influence and the interference with the signal line cannot occur in the DSP circuit board surface (x-y plane). A part or all of the DC wiring may be formed in the same surface layers 210a and 210b as a connection pad of the signal line or in the layer of the signal line 211 of the inner layer in (b) and (c) of Fig. 11.

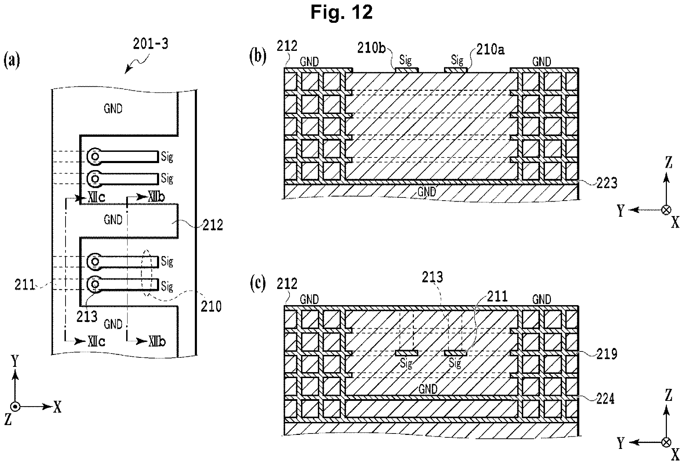

Fig. 12 is a diagram illustrating another configuration of a signal line in a multilayer wiring DSP circuit board including a core layer. (a) of Fig. 12 is a top view (x-y plane) illustrating an electrode configuration of an end portion of a DSP circuit board 201-3 solder-connected to the FPC. (b) of Fig. 12 is a cross-sectional view (y-z plane) obtained by vertically cutting the DSP circuit board along a line XIIb-XIIb, and illustrates the connection PAD of the signal line. (c) of Fig. 12 illustrates the signal line of the inner layer in a cross-sectional view (y-z plane) obtained by vertically cutting the DSP circuit board along a line XIIc-XIIc. Differences from the configuration of the multilayer wiring board 201-1 illustrated in Fig. 9 are the number of dielectric layers and the position of a layer used as a ground layer. In (a) of Fig. 12, five dielectric layers are used between the connection PADs 210a and 210b and the corresponding ground layer 223. In (c) of Fig. 12, two dielectric layers are used for each of the upper side and the lower side of the signal line 211 of the inner layer between the ground layer 224 and the ground layer 212. The layer structure of the multilayer wiring circuit board may be determined in consideration of the characteristic impedance necessary for the DSP circuit board, the PAD width, the signal line width, the high frequency loss, and the like.

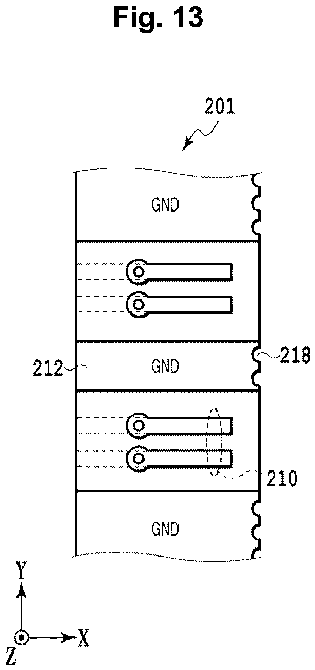

Fig. 13 is a view illustrating half-through holes formed at an end portion of a DSP circuit board. In order to reduce deterioration of high-frequency transmission characteristics in a case where a high-speed electrical signal is transmitted on a DSP circuit board, stability of a high-frequency ground is very important. As illustrated in Fig. 13, extending the ground PAD 212 to the circuit board end of the DSP circuit board 201 and introducing a half-through hole on the side surface of the circuit board are effective. Forming a conductor on the side surface of the circuit board to connect the upper and lower surfaces of the circuit board in this manner is also said to be castellation. There are various structures for castellation including an oval and the like, in addition to a semicircular half-through hole as illustrated in Fig. 13. The high-frequency ground potential of the ground PAD connected to the FPC together with the connection PAD 210 is stabilized, and transmission of a high-frequency electrical signal from the connection PAD 403 of the optical module to the connection PAD 210 is stabilized.

Although both the terms through hole and VIA are used in the above description, both can be replaced. Furthermore, the configuration of the multilayer wiring circuit board can be variously modified, and is not limited to the above-described example.

In the above description, the Tx module and the Rx module are separately packaged as an example. However, the configuration of the optical transceiver of the present invention is also effective in an optical transceiving module form (such as IC-TROSA) in which the optical modulator and the optical receiver are packaged in the same package form, other package forms, and the like.

### Industrial Applicability

The present invention can be used for optical communication.

### Reference Signs List

100, 100-1 to 100-3, 800 Optical transceiver
101, 801 PCB
200, 802 DSP
201, 201-1 to 201-3, 804 DSP circuit board
202, 805 DSP chip
203, 203a to 203c Lid
204, 205, 803 BGA
206, 404 Solder
210, 403, 505, 507 Connection PAD
211, 502, 502a, 502b Signal line
212 GND PAD
213, 215, 508, 509 VIA
214-1 to 214-3 DC line
216, 217, 223, 503 GND layer
300 Rx module
301, 401 Lead pin
302, 402, 808 Optical fiber
400, 807 Tx module
405 Package side wall
406 Peltier element
408 Driver IC
409 Optical modulator chip
415, 416 Base layer
417 Housing
500, 500-1, 500-2, 500a, 500b, 806 FPC
501 Base material
504, 506 Heating PAD
513a to 514c Void

## Claims

1. An optical transceiver comprising:
at least one optical module mounted on a printed circuit board (PCB);
a digital signal processor (DSP) mounted on the PCB; and
a flexible wiring board (flexible printed circuit [FPC]) that connects the DSP and the optical module, wherein
the DSP includes a DSP chip mounted on a DSP circuit board,
the FPC includes a first connection PAD of a first surface solder-connected to a PAD of a terrace surface of the optical module and a second connection PAD of a second surface solder-connected to a PAD of an upper surface of the DSP circuit board, and
the PAD of the DSP circuit board is connected to the DSP chip by a signal line of an inner layer of a multilayer wiring circuit board from the PAD on the DSP circuit board via a via (VIA).

2. The optical transceiver according to claim 1, wherein
the DSP further includes a lid that covers a region of the DSP circuit board including at least a region of the DSP chip and excluding the PAD.

3. The optical transceiver according to claim 1,
wherein
in the DSP circuit board,
a thickness of a dielectric layer per layer is 0.1 mm or less in a wiring layer including the signal line, and
a first metal layer that forms the PAD and a first ground layer for the signal line,
a second metal layer that forms the signal line,
a third metal layer that forms a second ground layer for the signal line, and
a fourth metal layer that forms a direct current wiring to the DSP chip
are included in this order in a thickness direction.

4. The optical transceiver according to claim 3,
wherein
the PAD of the DSP circuit board
does not include another metal conductor in a region between adjacent ground PADs in a cross section perpendicular to a longitudinal direction, the region being in a range of at least 0.1 mm or more in a circuit board thickness direction,
an end of the PAD on a circuit board end side in the longitudinal direction is located on an inner side of a circuit board by 0.1 mm or more from a corresponding end of the adjacent ground PADs, and
the PAD has a length of 1 mm or less and a width of 0.2 mm or less.

5. The optical transceiver according to claim 1,
wherein
the first connection PAD includes a first heating PAD connected by one or more through holes or embedded VIAs at a corresponding position on a side of the second surface,
the second connection PAD includes a second heating PAD connected by one or more through holes or embedded VIAs at a corresponding position on a side of the first surface, and
the second connection PAD is shorter than the PAD on the DSP circuit board by at least 100 um in a longitudinal direction.

6. The optical transceiver according to claim 1, wherein the PAD of the DSP circuit board has a width narrower than a width of a connection PAD of the FPC.

7. The optical transceiver according to claim 1, wherein a ground PAD adjacent to the PAD of the DSP circuit board extends to a circuit board end and includes a castellation structure on a circuit board side surface.

8. The optical transceiver according to claim 1, wherein the DSP circuit board includes a core layer, the core layer includes one or more embedded VIAs at a corresponding position of the connection PAD of the DSP circuit board, and a diameter of the embedded VIA is larger than a diameter of the VIA used for the signal line.

9. The optical transceiver according to claim 1, wherein the at least one optical module
includes: an optical transmitter module including an optical modulator and a driver integrated circuit; and an optical receiver module including a photodetector and a transimpedance amplifier, or
is a single optical transceiver module that includes functions of both the optical transmitter module and the optical receiver module, and
the at least one optical module is mounted such that the terrace surface faces an upper surface of the PCB, and a heat generating component is disposed inside a package such that heat is dissipated toward a surface opposite to a mounting surface for the PCB.
